# EUROPÄISCHE PATENTSCHRIFT

(11) **EP 0 933 818 B1**
(45) Veröffentlichungstag und Bekanntmachung des Hinweises auf die Patenterteilung: **12.02.2003**
(21) Anmeldenummer: 98123776.1
(22) Anmeldetag: 14.12.1998
(51) Int. Cl.: H01L 27/142, H01L 31/042, H01L 31/05

(54) **Solarmodul in integrierter Dünnschichttechnik**
Solar module in integrated thin film technology
Module solaire en technologie de films minces intégrés

(30) Priorität: 29.01.1998 DE 19803326
(43) Veröffentlichungstag der Anmeldung: 04.08.1999
(73) Patentinhaber: RWE Solar GmbH, 63755 Alzenau (DE)
(72) Erfinder: Psyk, Walter, 81371 München (DE); Lechner, Peter, 85591 Vaterstetten (DE)
(74) Vertreter: Haft, von Puttkamer, Berngruber, Czybulka

(56) Entgegenhaltungen:
- EP-A- 0 427 934
- EP-A- 0 768 720
- DE-A- 3 517 414
- DE-A- 4 039 945
- FR-A- 2 639 475
- US-A- 4 933 022
- PATENT ABSTRACTS OF JAPAN vol. 015, no. 078 (E-1037), 22. Februar 1991 & JP 02 298080 A (SHARP CORP), 10. Dezember 1990
- PATENT ABSTRACTS OF JAPAN vol. 097, no. 007, 31. Juli 1997 -& JP 09 064397 A (CANON INC), 7. März 1997
- PATENT ABSTRACTS OF JAPAN vol. 013, no. 026 (E-706), 20. Januar 1989 -& JP 63 228766 A (KOMATSU LTD), 22. September 1988

## Beschreibung

Die Erfindung betrifft ein Solarmodul in integrierter Dünnschichttechnik.
Ein derartiges Solarmodul ist aus der DE 4039945 C2 bekannt. Demnach sind auf einem gemeinsamen Substrat eine Anzahl hintereinander angeordneter, in Reihe geschalteter Solarzellen sowie eine Anzahl parallel und benachbart dazu gleichfalls hintereinander angeordneter, in Reihe geschalteter Dioden aufgebracht. Letztere bestehen ebenso wie die Solarzellen aus einer vorderseitigen und einer rückseitigen Elektrodenschicht sowie einer dazwischen angeordneten, photovoltaisch aktiven Schichtfolge. Die Reihenschaltung der Solarzellen einerseits sowie der Dioden andererseits ist bei dem bekannten Solarmodul in üblicher Weise dadurch erzeugt, daß jeweils die vorderseitige Elektrodenschicht einer Solarzelle oder Diode mit der rückseitigen Elektrodenschicht der direkt benachbarten Solarzelle bzw. Diode unmittelbar elektrisch kontaktiert ist. Dies geschieht durch seitliche Herausführung der jeweiligen Elektrodenschichten über den Bereich der zwischen ihnen angeordneten photovoltaisch aktiven Schichtfolge hinaus. Die in Reihe geschalteten Solarzellen einerseits sowie die in Reihe geschalteten Dioden andererseits sind, bis auf jeweils gemeinsame vorderseitige Elektrodenschichten der zwei ganz außen liegenden Solarzellen sowie Dioden, mittels eines durchlaufenden Grabens voneinander getrennt. Die Gesamtheit der in Reihe geschalteten Solarzellen ist also zu der Gesamtheit der in Reihe geschalteten Dioden parallel geschaltet.

Das bekannte Solarmodul wird jedoch einer häufig auftretenden Problematik nicht in optimaler Weise gerecht, nämlich der durch teilweise Abschattung des Solarmoduls bewirkten Gefahr einer Beschädigung. Wird nämlich auch nur eine einzige Solarzelle beschattet, was leicht bei schräg einfallender Sonnenstrahlung am Rand des Moduls durch Schattenwurf z.B. eines Rahmens auftreten kann, so wird der generierte Photostrom des Solarmoduls begrenzt durch den wesentlich kleineren Photostrom der einen beschatteten Solarzelle. Gleichzeitig bildet sich an der beschatteten Solarzelle eine hohe, in Rückwärtsrichtung anliegende Spannung aus, die zu einem elektrischen Durchbruch dieser Solarzelle und zu ihrer irreversiblen Beschädigung führen kann.

Um dieses Phänomen auf optimale Weise zu verhindern, muß in Sperrichtung zu jeder einzelnen Solarzelle eine Diode geschaltet werden. Dies ist bei dem bekannten Solarmodul nicht der Fall, denn dort liegt eine Reihenschaltung von Dioden parallel zu den in Reihe geschalteten Solarzellen, und dies noch nicht einmal in Sperrichtung.

Zwar ist es an sich bekannt, dem Problem der Abschattung dadurch zu begegnen, daß den einzelnen Solarzellen in Sperrichtung geschaltete Dioden zugeordnet sind. Bei der hierzu in Figur 5 der DE 3517414 A1 abgebildeten Version handelt es sich jeweils um separate Solarzellen, welche durch externe Verdrahtung untereinander in Reihe geschaltet sind. Jeder dieser Solarzellen ist eine eigene Diode zugeordnet, welche sich gemeinsam mit dieser Solarzelle auf demselben Einzelsubstrat befindet und auch im wesentlichen denselben Schichtaufbau besitzt, welche jedoch wiederum elektrisch der benachbarten Solarzelle angehört und über eine externe Verdrahtung zu dieser in Sperrichtung geschaltet ist. Der Gesamtaufbau dieser bekannten Version ist jedoch ersichtlich aufwendig, da zwar jede einzelne Solarzelle mit jeweils einer Diode strukturell integriert ist, es sich jedoch um kein in integrierter Dünnschichttechnik hergestelltes Gasamtmodul handelt.

Bei der in den Figuren 1 und 2 einer weiteren bekannten in der JP 63-228766 A abgebildeten Version gemäß dem Oberbegriff des Patentansprüchs 1 handelt es sich um in Serie verschaltete Dünnschichtsolarzellen aus amorphem Silizium des p-i-n-Typs, denen antiparallel und in Serie verschaltet Dioden zugeordnet sind. Den Dioden kommt die Aufgabe zu, einen bei Beschattung durch erhöhten Serienwiderstand der Zelle eventuell auftretenden Leistungsverlust zu verhindern. Solarzellen und Dioden sind übereinander angeordnet, wobei auf einem Trägersubstrat eine erste und eine zweite Elektrodenschicht mit einer dazwischen liegenden photovoltaisch aktiven Schicht aufgetragen ist, wodurch die Solarzelle gebildet wird. Auf dieser Solarzelle wird eine weitere Halbleiterschicht und darüber eine dritte Elektrodenschicht aufgetragen, wodurch die Dioden gebildet werden. Daraus ergibt sich ein vertikaler. Aufbau einer Einheit aus Solarzelle und Diode. Die Dioden werden durch einen zweiten gegenüber der eigentlichen Solarzelle in der Abscheidesequenz umgedrehten Herstellprozeß (n-i-p) realisiert. Dieses Verfahren erfordert zusätzlich nach den beiden getrennten Abscheidungen für die Solarzelle und die Diode jeweils eine Metallisierung und mehrere Strukturierungsschritte. Der Gesamtaufbau dieser Version ist ersichtlich kompliziert und offensichtlich prozeßtech = nisch schwer beherrschbar.

Aus US-A-4 933 022 ist ein Solarmodul bekannt, bei dem zu jeder einzelnen Solarzelle eine Diode in Sperrrichtung parallel geschaltet ist. Jedoch werden die Solarzellen und Dioden auf dem Substrat durch nebeneinander in abwechselnden Reihen in T-Form angeordnete unterschiedlich dotierte Bereich gebildet. Dabei ist das Material der Dioden von dem der Solarzellen verschieden. Die elektrische Verschaltung der Solarzellen und der Dioden entsteht durch zusätzliche seitlich angebrachte Metallkontakte. Die Herstellung dieser Solarmodule erfolgt nicht in integrierter Dünnschichttechnik und ist im Vergleich zu dieser wesentlich aufwendiger.

In EP-A-0 427 934 ist ein Solarmodul in integrierter Dünnschichttechnik mit einer bezogen auf den Lichteinfall auf das Substrat vorderseitigen und einer rückseitigen Elektrodenschicht und mit einer photovoltaisch aktiven Schicht beschrieben. Dabei entsteht die Strukturierung der einzelnen Solarzellen durch Gräbensysteme in den jeweiligen Schichten. Jedoch entsteht bei den dort beschriebenen Gräben ein inaktiver Bereich in der photovoltaisch aktiven Schicht, der nicht zur Erzeugung von Elektrizität beiträgt. Ferner sind dort keine Dioden zum Schutz der Solarzellen vorgesehen.

Der Erfindung liegt nun die Aufgabe zugrunde, ein Solarmodul der eingangs genannten Art bereitzustellen, welches in integrierter Dünnschichttechnik herstellbar ist und zu jeder einzelnen Solarzelle eine in Sperrichtung geschaltete Diode aufweist.

Diese Aufgabe ist gemäß der Erfindung durch die im kennzeichnenden Teil des Patentanspruchs 1 aufgeführten Merkmale gelöst.

Demnach ist zunächst vorgesehen, daß die vorderseitigen und rückseitigen Elektrodenschichten benachbarter Dioden nicht unmittelbar miteinander elektrisch kontaktiert sind, wie dies noch bei dem Solarmodul der DE 4039945 C2 der Fall ist. Dadurch ist die unmittelbare Reihenschaltung der Dioden aufgehoben. Weiterhin sollen Überlappungszonen dadurch gebildet sein, daß jeweils ein vorspringender Randbereich einer Elektrodenschicht einer Solarzelle oder Diode in eine Ausnehmung der entsprechenden Elektrodenschicht der benachbarten Diode bzw. Solarzelle eingreift und so die darüber- oder darunterliegende Zone der jeweils anderen Elektrodenschicht dieser benachbarten Diode bzw. Solarzelle überlappt. Schließlich soll jede Diode mit der benachbarten Solarzelle in mindestens 2 derartigen Überlappungszonen in Sperrichtung verschaltet sein, wobei in mindestens einer dieser Überlappungszonen die vorderseitige Elektrodenschicht der betreffenden Diode mit der rückseitigen Elektrodenschicht der betreffenden Solarzelle und in mindestens einer anderen dieser Überlappungszonen die rückseitige Elektrodenschicht dieser Diode mit der vorderseitigen Elektrodenschicht dieser Solarzelle elektrisch kontaktiert ist.

Die erwähnten Überlappungszonen lassen sich, was später anhand des Ausführungsbeispiels noch deutlicher wird, im Zuge des integrierten Herstellungsprozesses durch entsprechende Strukturierung der jeweiligen Elektrodenschichten auf einfache, zeitsparende und kostengünstige Weise erzeugen. Durch die Kontaktierung in diesen Überlappungsbereichen wird auch sichergestellt, daß einmal einer jeden einzelnen Solarzelle eine zu ihr in Sperrichtung geschaltete Diode zugeordnet ist, zum anderen wird dadurch bewirkt, daß die Dioden insgesamt in Reihe geschaltet sind, allerdings in umgekehrter Richtung wie die Solarzellen. Während die Reihenschaltung der Solarzellen in üblicher Weise unmittelbar erfolgt, nämlich durch Kontaktierung der vorderseitigen Elektrodenschicht einer Solarzelle mit der rückseitigen Elektrodenschicht der jeweils benachbarten Solarzelle, erfolgt die Reihenschaltung der Dioden sozusagen auf dem Umweg über die Überlappungszonen sowie die Elektrodenschichten der jeweils zugeordneten Solarzellen.
Im folgenden ist ein Ausführungsbeispiel der Erfindung anhand der Abbildungen näher erläutert. Es zeigen in schematischer Weise:
Figur 1 ein Ersatzschaltbild eines Teils des Solarmoduls,
Figur 2 einen Teil des Solarmoduls in Draufsicht,
Figur 3 einen ersten Querschnitt durch diesen Teil des Solarmdoduls entlang der SchnittlinieA-A,
Figur 4 einen zweiten Schnitt entlang der Schnittlinie B-B,
Figur 5 einen dritten Schnitt entlang der Schnittlinie C-C,
Figuren 6 - 8 drei unterschiedliche Versionen von Überlappungszonen.

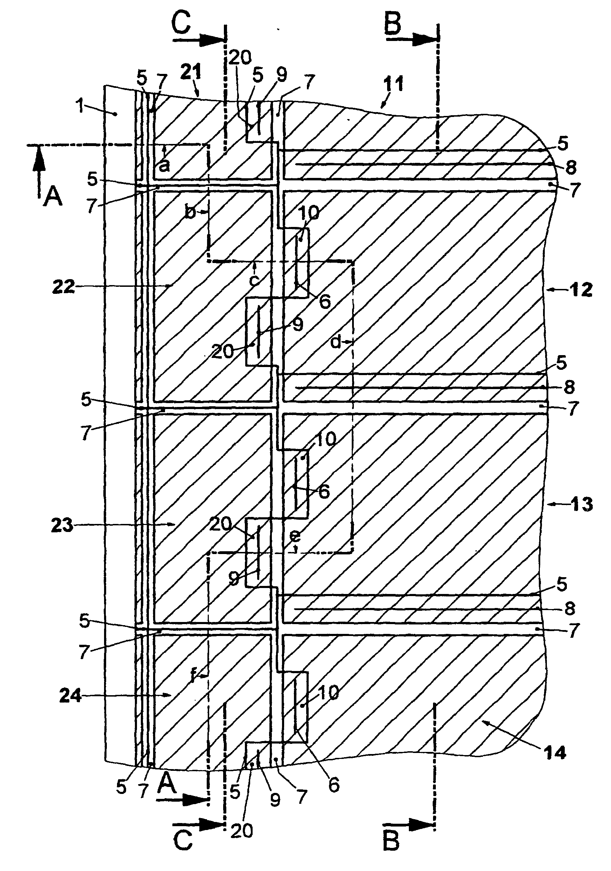

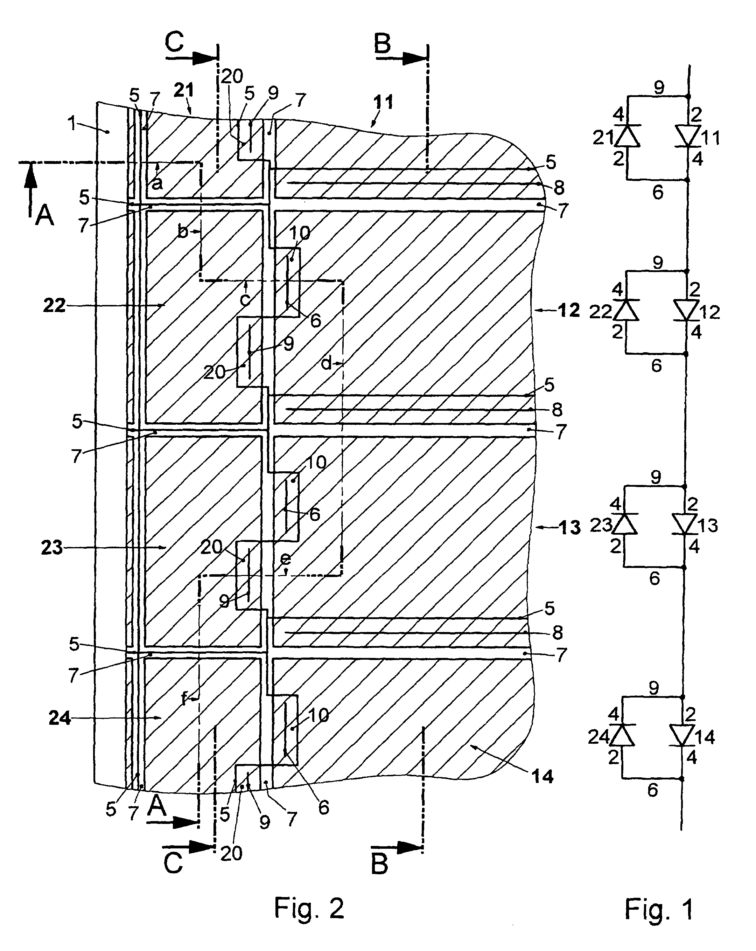

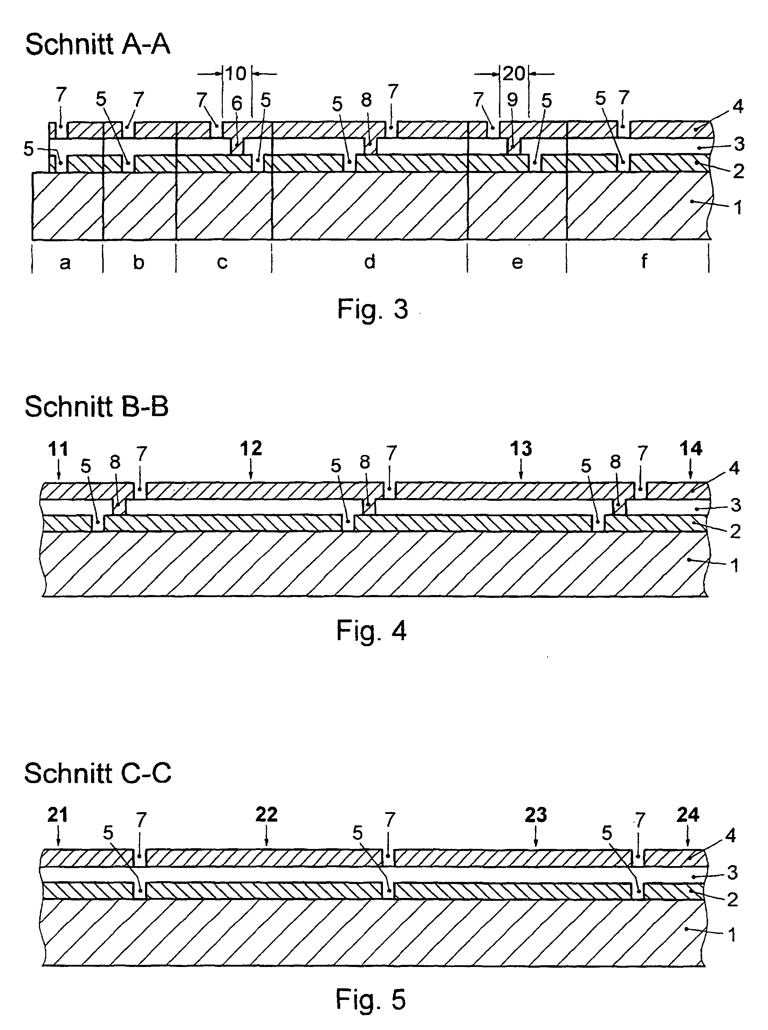

Die Draufsicht der Figur 2 zeigt einen Ausschnitt aus einem Solarmodul gemäß der Erfindung, mit Solarzellen 11, 12, 13 sowie 14 und Dioden 21, 22, 23 sowie 24. Dabei ist im wesentlichen die Strukturierung der jeweiligen vorderseitigen und rückseitigen Elektrodenschichten dargestellt. Diese erfolgt einmal durch ein erstes System von Gräben 5 sowie zum anderen durch ein zweites System von Gräben 7. Aus Gründen besserer Übersichtlichkeit sind die Gräben 5 im Gegensatz zu den Gräben 7 lediglich als dick ausgezogene Linien dargestellt. Die durch die Gräben 7 strukturierten rückseitigen Elektrodenschichten sind schräg schraffiert. Durch entsprechende Führung der Gräben 5 sind in den vorderseitigen Elektrodenschichten der Solarzellen und Dioden jeweils vorspringende Randbereiche und Ausnehmungen ausgebildet, so daß sich Überlappungszonen 10 bzw. 20 ergeben, in denen diese vorspringenden Randbereiche jeweils unter die darüberliegenden Randzonen rückseitiger Elektrodenschichten zu liegen kommen. Dargestellt sind noch Gräben 8 sowie 6 und 9, die der elektrischen Kontaktierung sich jeweils überlappender Elektrodenschichten dienen, wobei diese Kontaktierung durch die zwischen den Elektrodenschichten befindliche, photovoltaisch aktive Schichtfolge, welche in Figur 2 nicht explizit dargestellt ist, hindurch erfolgt, wie es aus den Schnittdarstellungen der Figuren 3 - 5 im Detail hervorgeht.

Zunächst ist in Figur 4 ein Schnitt nur durch die Solarzellen 11, 12, 13 sowie 14 dargestellt. Diese sind, wie üblich, auf integrierte Weise in Reihe geschaltet. Auf einem in diesem Ausführungsbeispiel transparenten Substrat 1, beispielsweise einer Glasscheibe, sind zunächst die durch Gräben 5 strukturierten vorderseitigen Elektrodenschichten 2 aufgebracht. Darauf befindet sich eine durchgehende photovoltaisch aktive Schichtfolge 3, in welche einzelne Gräben 8 eingeschnitten sind, die der Reihenverschaltung dienen. Durch Gräben 7 voneinander separierte rückseitige Elektrodenschichten 4 liegen auf der photovoltaisch aktiven Schichtfolge 3, wobei das Material dieser rückseitigen Elektrodenschichten 4 in den Gräben 8 jeweils bis auf die Oberfläche der vorderseitigen Elektrodenschichten 2 herabreicht und so die für die Reihenschaltung erforderliche elektrische Kontaktierung bewirkt. Die photovoltaisch aktive Schichtfolge kann beispielsweise als pin-Struktur auf der Basis amorphen Siliziums ausgeführt sein, jedoch kommen auch alle anderen in der Solarzellentechnik üblichen Materialien bzw. Schichtfolgen infrage, die zur Erzeugung und Trennung elektrischer Ladungen
bei Lichteinfall geeignet sind. Als vorderseitige Elektrodenschicht 2 wird zweckmäßig eine transparente leitende Oxidschicht, beispielsweise aus Zinnoxid bestehend, verwendet, als rückseitige Elektrodenschicht 4 eine elektrisch gut leitende, nicht transparente Metallschicht, welche auch aus mehreren übereinanderliegenden Unterschichten jeweils verschiedenen Materials bestehen kann.

Der in Figur 5 gezeigte Schnitt ist durch die hintereinander angeordneten Dioden 21, 22, 23 sowie 24 geführt. Auch diese bestehen, ebenso wie die Solarzellen, aus vorderseitigen Elektrodenschichten 2, rückseitigen Elektrodenschichten 4 sowie der bereits erwähnten, dazwischenliegenden, durchgehenden, photovoltaisch aktiven Schichtfolge 3. Letztere greift in die Gräben 5 ein, welche hier nicht mehr wie in Figur 2 lediglich als Linien, sondern mit einer gewissen Breite dargestellt sind. Die darüber befindlichen Gräben 7 haben in Figur 5 jeweils dieselbe Breite wie die Gräben 5, was jedoch nicht notwendigerweise der Fall sein muß. Durch beide Grabensysteme sind die Dioden 21, 22, 23 sowie 24, jedenfalls in der dargestellten Schnittebene, elektrisch praktisch voneinander isoliert, da die dazwischenliegende photovoltaisch aktive Schichtfolge 3 nur über eine sehr geringe elektrische Leitfähigkeit verfügt und im vorliegenden Zusammenhang als elektrisch isolierend angesehen werden kann. Bei nicht ausreichender Isolierung kann die photovoltaisch aktive Schichtfolge 3 ebenfalls durch einen Graben getrennt werden.

In Figur 3 ist ein geknickter Querschnitt gemäß der Linie A-A in Figur 2 dargestellt, der in insgesamt 6 Abschnitte a - f, die jeweils in sich gradlinig geführt sind, unterteilt ist.

Die Bezeichnungen sind wie in den Figuren 4 und 5 gewählt. Die Abschnitte b sowie f entsprechen Teilausschnitten aus Figur 5, der Abschnitt d einem Teilausschnitt aus Figur 4. Die Abschnitte c sowie e sind jeweils durch Überlappungszonen 10 bzw. 20 geführt. In der ersten (10) dieser Überlappungszonen liegt ein vorspringender Randbereich der vorderseitigen Elektrodenschicht 2 der Diode 22 unter einer Randzone der rückseitigen Elektrodenschicht 4 der zugeordneten Solarzelle 12. Es ist ein Graben 6 vorhanden, in welchem das Material der rückseitigen Elektrodenschicht 4 der Solarzelle 12 durch die photovoltaisch aktive Schichtfolge 3 hindurch bis auf die Oberfläche des darunterliegenden Randbereiches der vorderseitigen Elektrodenschicht 2 der Diode 22 herabreicht, so daß dort die beiden genannten Elektrodenschichten miteinander elektrisch kontaktiert sind. Ähnliche Verhältnisse finden sich im Schnittbereich e, wo eine Überlappungszone 20 dargestellt ist, welche in diesem Falle durch einen vorspringenden Randbereich der vorderseitigen Elektrodenschicht 2 der Solarzelle 13 sowie die darüberliegende Randzone der rückseitigen Elektrodenschicht 4 der Diode 23 gebildet ist. Ein Graben 9 in der dazwischenliegenden photovoltaisch aktiven Schichtfolge 3 sorgt für die Kontaktierung zwischen den beiden genannten Schichten, und zwar mittels des in ihm bis auf die Oberfläche der vorderseitigen Elektrodenschicht 2 der Solarzelle 13 herabreichenden Materials der rückseitigen Elektrodenschicht 4 der Diode 23.

Im Ersatzschaltbild der Figur 1 sind neben den Solarzellen 11 - 14 sowie den Dioden 21 - 24 noch die jeweils zugehörigen vorderseitigen und rückseitigen Elektrodenschichten 2 bzw. 4 bezeichnet, welche jeweils in Gräben 6 und 9 der genannten, dort nicht dargestellten Übergangszonen 10 bzw. 20 miteinander kontaktiert sind. Die Reihenschaltung der Solarzellen 11 - 14 sowie indirekt auch der Dioden 21 - 24 erfolgt, wie bereits oben erwähnt, über die Gräben 8.

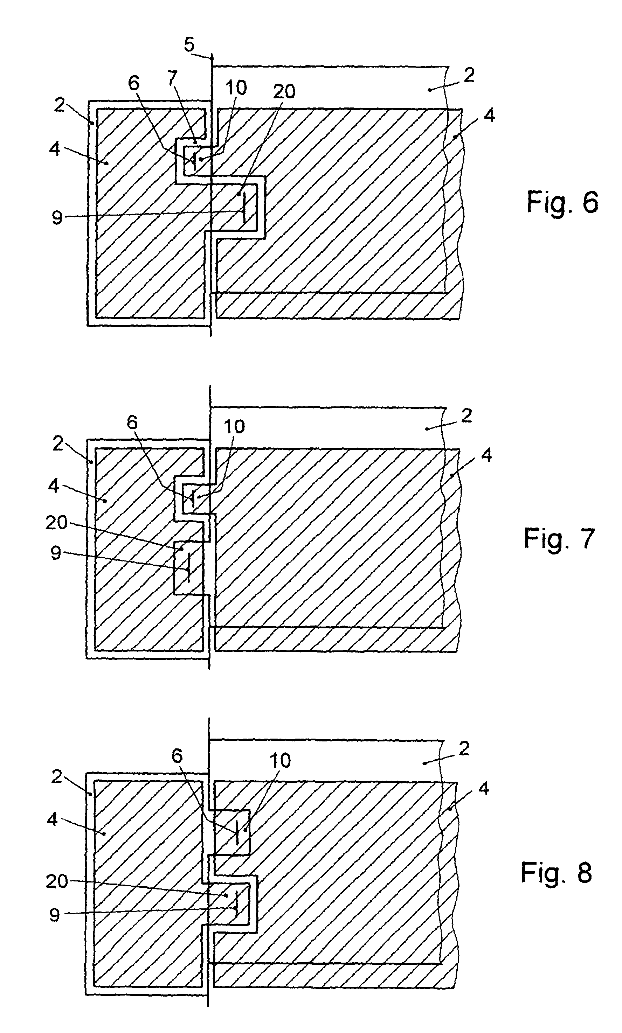

In den Figuren 6 - 8 sind noch Varianten in der Ausbildung der Übergangszonen 10 sowie 20 dargestellt. Während in der in Figur 2 abgebildeten Variante die Überlappungszonen 10 und 20 jeweils durch vorspringende Randbereiche sowie Ausnehmungen der vorderseitigen Elektrodenschichten der zusammengehörigen Solarzellen und Dioden gebildet sind, so geschieht dies beispielsweise gemäß Figur 6 durch vorspringende Randbereiche in den jeweiligen rückseitigen Elektrodenschichten 4. Demnach ist diesen beiden Ausführungsformen gemeinsam, daß sowohl die eine als auch die andere der Übergangszonen 10 sowie 20 einer Diode und der benachbarten Solarzelle durch vorspringende Randbereiche und Ausnehmungen jeweils der einander entsprechenden Elektrodenschichten, nämlich entweder der vorderseitigen oder der rückseitigen, gebildet sind.

In der Ausführungsform gemäß Figur 7 wird die Übergangszone 10 durch einen vorspringenden Randbereich der rückseitigen Elektrodenschicht 4 der Solarzelle und die Übergangszone 20 durch einen vorspringenden Randbereich der vorderseitigen Elektrodenschicht 2 ebenfalls der Solarzelle gebildet. Gemäß Figur 8 geschieht dies durch vorspringende Randbereiche jeweils der vorderseitigen sowie rückseitigen Elektrodenschicht lediglich der Diode. Demnach haben diese beiden Varianten gemeinsam, daß jeweils die eine der Übergangszonen durch einen vorspringenden Randbereich und eine Ausnehmung der vorderseitigen Elektrodenschichten und die andere der Übergangszonen durch einen vorspringenden Randbereich und eine Ausnehmung der rückseitigen Elektrodenschichten der jeweils beteiligten Diode und Solarzelle gebildet sind.

In den Figuren 6 - 8 ist jeweils ein Paar, bestehend aus einer Diode (links) und der ihr zugeordneten Solarzelle (rechts), dargestellt. Gezeigt sind, analog zu Figur 2, die jeweiligen vorderseitigen und rückseitigen Elektrodenschichten 2 bzw. 4, die diese jeweils trennenden Systeme von Gräben 5 und 7 sowie die mindestens erforderlichen zwei Überlappungszonen 10 und 20 mit den darin zur Kontaktierung vorhandenen Gräben 6 bzw. 9 in der zwischen den vorder- und rückseitigen Elektrodenschichten 2 bzw. 4 liegenden photovoltaisch aktiven Schichtfolge, die auch hier nicht explizit dargestellt ist. Ebenfalls nicht dargestellt sind die Gräben 8 zur Reihenverschaltung benachbarter Solarzellen

## Patentansprüche

1. Solarmodul in integrierter Dünnschichttechnik mit einer Anzahl auf einem gemeinsamen Substrat (1) hintereinander angeordneter, in Reihe geschalteter Solarzellen (11, 12, 13, 14) sowie einer Anzahl parallel und benachbart dazu auf demselben Substrat gleichfalls hintereinander angeordneter, in Reihe geschalteter Dioden (21, 22, 23, 24), wobei die Solarzellen und Dioden bestehend aus zwei Elektrodenschichten (2, 4), einer gleichen vorderseitigen und einer gleichen rückseitigen, und einer gleichen dazwischen angeordneten photovoltaisch aktiven Schicht (3) dadurch gebildet werden, daß die Schichten durch Gräben (5, 7, 8) unterteilt sind und eine elektrische Kontaktierung der vorderseitigen mit der rückseitigen Elektrodenschicht entsteht, indem das Material der später abgeschiedenen Elektrodenschicht (4) durch einen Graben in der photovoltaisch aktiven Schicht (3) hindurch auf die Oberfläche der früher abgeschiedenen Elektrodenschicht (2) herabreicht, wobei die vorderseitigen und rückseitigen Elektrodenschichten (2, 4) benachbarter Dioden (21, 22, 23, 24) nicht unmittelbar miteinander elektrisch kontaktiert sind und Überlappungszonen (10, 20) zwischen jeweils einer Diode und ihrer benachbarten Solarzelle dadurch gebildet sind, dass jeweils ein vorspringender Randbereich einer Elektrodenschicht (2, 4) einer Solarzelle (11, 12, 13, 14) oder Diode (21, 22, 23, 24) in eine Ausnehmung der entsprechenden Elektrodenschicht (2, 4) der benachbarten Diode bzw. Solarzelle eingreift und so die darüber- oder darunterliegende Zone der jeweils anderen Elektrodenschicht (4, 2) dieser benachbarten Diode bzw. Solarzelle überlappt, **dadurch gekennzeichnet, dass** jede Diode mit der benachbarten Solarzelle in mindestens zwei Überlappungszonen (10, 20) in Sperrichtung verschaltet ist, und dass in einer dieser Überlappungszonen (10) die vorderseitige Elektrodenschicht (2) der betreffenden Diode mit der rückseitigen Elektrodenschicht (4) der betreffenden Solarzelle und in einer anderen dieser Überlappungszonen (20) die rückseitige Elektrodenschicht (4) dieser Diode mit der vorderseitigen Elektrodenschicht (2) dieser Solarzelle elektrisch kontaktiert ist.

2. Solarmodul nach Anspruch 1, **dadurch gekennzeichnet, daß** jeweils die eine der Überlappungszonen (10, 20) durch einen vorspringenden Randbereich und eine Ausnehmung der vorderseitigen Elektrodenschichten und die andere der Überlappungszonen (20, 10) durch einen vorspringenden Randbereich und eine Ausnehmung der rückseitigen Elektrodenschichten der jeweils beteiligten Diode und Solarzelle gebildet sind.

3. Solarmodul nach einem der vorhergehenden Ansprüche, **dadurch gekennzeichnet, daß** die elektrische Kontaktierung der vorderseitigen mit der rückseitigen Elektrodenschicht (2, 4) in den jeweiligen Überlappungszonen (10, 20) durch Öffnungen (6, 9) in der photovoltaisch aktiven Schichtfolge (3) hindurch erfolgt.

## Claims

1. A thin-film solar module having a number of solar cells (11, 12, 13, 14) tandem mounted and series-connected on a common substrate (1) and a number of diodes (21, 22, 23, 24) likewise tandem mounted and series-connected on the same substrate parallel and adjacent to said solar cells, said solar cells and diodes consisting of two electrode layers (2, 4), a like front one and a like back one, and a like intermediate photovoltaically active layer (3) and being formed by the layers being divided by grooves (5, 7, 8) and an electric contacting of the front with the back electrode layers arising by the material of the later deposited electrode layer (4) extending through a groove in the photovoltaically active layer (3) down to the surface of the earlier deposited electrode layer (2), the front and back electrode layers (2, 4) of adjacent diodes (21, 22, 23, 24) not being electrically contacted directly with each other, and overlap zones (10, 20) being formed between each diode and its adjacent solar cell by a projecting edge area of an electrode layer (2, 4) of a solar cell (11, 12, 13, 14) or diode (21, 22, 23, 24) engaging a recess in the corresponding electrode layer (2, 4) of the adjacent diode or solar cell and thus overlapping the superjacent or subjacent zone of the other electrode layer (4, 2) of said adjacent diode or solar cell, **characterized in that** each diode is connected in the reverse direction with the adjacent solar cell in at least two overlap zones (10, 20), and the front electrode layer (2) of the particular diode is electrically contacted with the back electrode layer (4) of the particular solar cell in one of said overlap zones (10), and the back electrode layer (4) of said diode with the front electrode layer (2) of said solar cell in another of said overlap zones (20).

2. A solar module according to claim 1, **characterized in that** one of the overlap zones (10, 20) is formed by a projecting edge area and a recess in the front electrode layers, and the other of the overlap zones (20, 10) by a projecting edge area and a recess in the back electrode layers of the involved diode and solar cell.

3. A solar module according to either of the above claims, **characterized in that** the electric contacting of the front with the back electrode layers (2, 4) in the particular overlap zones (10, 20) is effected through openings (6, 9) in the photovoltaically active layer sequence (3).

## Revendications

1. Module solaire en technologie de couches minces intégrées comportant un nombre de cellules solaires (11, 12, 13, 14) montées en série, agencées les unes derrière les autres sur un substrat commun (1), ainsi qu'un nombre de diodes (21, 22, 23, 24) montées en série, également agencées les unes derrière les autres, parallèlement et au voisinage de celles-ci sur le même substrat, les cellules solaires et les diodes, constituées par deux couches d'électrodes (2, 4), une même couche antérieure et une même couche postérieure et par une même couche (3) photovoltaïquement active, agencée entre celles-ci, étant formées par le fait que les couches sont divisées par des tranchées (5, 7, 8) et qu'il se produit un contact électrique entre la couche d'électrode antérieure et la couche d'électrode postérieure, en faisant arriver le matériau de la couche d'électrode ultérieurement déposée à travers une tranchée dans la couche (3) photovoltaïquement active, sur la surface de la couche d'électrode (2) déposée auparavant, les couches d'électrodes antérieure et postérieure (2, 4) de diodes voisines (21, 22, 23, 24) n'étant pas directement en contact électrique l'une avec l'autre et des zones de chevauchement (10, 20) étant formées entre une diode respective et sa cellule solaire voisine par le fait qu'une région de bordure respective en saillie d'une couche d'électrode (2, 4) d'une cellule solaire (11, 12, 13, 14) ou d'une diode (21, 22, 23, 24) s'engage dans un évidement de la couche d'électrode (2, 4) correspondante de la diode voisine ou de la cellule solaire voisine et chevauche ainsi la zone située en dessus ou en dessous de l'autre couche d'électrode (2, 4) respective de cette diode voisine ou cellule solaire voisine, **caractérisé en ce que** chaque diode est connectée en direction de blocage avec la cellule solaire voisine dans au moins deux zones de chevauchement (10, 20), et **en ce que** dans une de ces zones de chevauchement (10), la couche d'électrode antérieure (2) de la diode concernée est en contact électrique avec la couche d'électrode postérieure (4) de la cellule solaire concernée et dans une autre de ces zones de chevauchement (20), la couche d'électrode postérieure (4) de cette diode est en contact électrique avec la couche d'électrode (2) antérieure de cette cellule solaire.

2. Module solaire selon la revendication 1, **caractérisé en ce qu'**une des zones de chevauchement (10, 20) respective est formée par une région de bordure en saillie et par un évidement des couches d'électrodes antérieures et l'autre zone de chevauchement (20, 10) est formée par une région de bordure en saillie et par un évidement des couches d'électrodes postérieures de la diode et de la cellule solaire respectivement concernées.

3. Module solaire selon l'une quelconque des revendications précédentes, **caractérisé en ce que** le contact électrique entre la couche d'électrode antérieure (2) et la couche d'électrode postérieure (4) dans les zones de chevauchement (10, 20) respectives a lieu à travers des ouvertures (6, 9) dans la succession de couches (3) photovoltaïquement actives.
